(19) Europäisches Patentamt
European Patent Office
Office européen des brevets

(11) **EP 3 182 151 A1**

(12) **EUROPEAN PATENT APPLICATION**

(43) Date of publication:
**21.06.2017 Bulletin 2017/25**

(21) Application number: **15250021.1**

(22) Date of filing: **18.12.2015**

(51) Int Cl.:
*G01S 7/282* (2006.01)          *H01Q 7/00* (2006.01)
*H01Q 13/08* (2006.01)          *H01Q 21/06* (2006.01)
*H03K 3/53* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **BAE Systems PLC
London SW1Y 5AD (GB)**

(72) Inventor: **The designation of the inventor has not
yet been filed**

(74) Representative: **BAE SYSTEMS plc
Group IP Department
P.O. Box 87
Warwick House
Farnborough Aerospace Centre
Farnborough
Hampshire GU14 6YU (GB)**

(54) **ELECTROMAGNETIC ENERGY TRANSMISSION**

(57)     An electromagnetic signal transmission system having an operating frequency range and a cut-off frequency, the electromagnetic signal transmission system comprising: a control system, a pulse source in communication with the control system, a plurality of transmission units, each being operably connected to the pulse source, and each transmission unit comprising a modulator arranged to receive a pulse signal from the pulse source and output a modulated signal, and an antenna element arranged to receive the modulated signal from the modulator wherein the antenna element comprises at least two conductive loops.

Fig 8

107

100

105

Pulse Source(s)
**104**

Control
System
**102**

106 — Antenna 1

106 — Antenna 1

106 — Antenna 1

106 — Antenna 1

106 — Antenna 1

## Description

This invention relates to an electromagnetic energy transmission system.

Wide band technology is increasingly being developed for communications and other applications. Unlike narrow band systems, which operate at specific frequencies, wide band systems can transmit and receive sequences of very short pulses, i.e. pulses generated from a broad range or bandwidth of frequencies (typically several MHz to several GHz) of the electromagnetic spectrum. The input to a wide band antenna is typically from one or more pulsed sources, and the antenna is required to radiate incident energy into free space.

According to a first aspect of the invention there is provided an electromagnetic signal transmission system having an operating frequency range and a cut-off frequency, the electromagnetic signal transmission system comprising: a control system, a pulse source in communication with the control system, a plurality of transmission units, each being operably connected to the pulse source, and each transmission unit comprising a modulator arranged to receive a pulse signal from the pulse source and output a modulated signal, and an antenna element arranged to receive the modulated signal from the modulator wherein the antenna element comprises at least two conductive loops.

As such there is provided a wide band energy transmission system. The provision of at least two conductive loops tends to provide an integrated antenna to make efficient use of space and weight and accordingly provide a system which makes efficient use of space and weight.

The modulator may tend to output a signal that has higher frequency components as compared to a signal input to the modulator and further, the higher frequency components comprise microwave frequency components.

As such the system tends to be disposed to transmitting high frequency energy, in addition to or as an alternative to lower frequency energies.

In certain embodiments, the modulator comprises a transmission line surrounded by a magnetising structure.

Such a modulator may be referred to as a microwave frequency modulator.

Each antenna element may comprise an upper loop and a lower loop, said upper loop comprising a first conductive loop element defined by an upper conductor and a first conductive blade member that tapers outwardly to form a flare portion adjacent a distal end of said upper conductor, said lower loop comprising a second conductive loop element defined by a base conductor and a second conductive blade member that tapers outwardly to form a flare portion adjacent a distal end of said base conductor, said first and second conductive blade members defining, between their facing edges, a notch which opens outwardly from a feed region, said upper loop further comprising an elongate conductive vane extending at an angle from a first location on said upper conductor to a second location on said first conductive blade to define a pair of loops within said upper loop.

The applicant has determined that such antenna elements are surprisingly well suited to wideband energy transmission.

Further, such antenna elements may have an impedance of said antenna element configured to substantially match, at said desired operating frequency range, an impedance of the modulator connected at said feed region thereof; and: said conductive vane may be located within said upper loop such that it extends from a selected second location on said first conductive blade to a first location on said upper conductor, said selected second location corresponding to a minimum distance from said feed region at which said impedance match is maintained.

In particular, the second location on the first blade member may be at least 1/6 of the length of the upper conductor.

Such configurations have been determined by the applicant to offer surprisingly broad performance.

Still further, the impedance of said antenna element may substantially match, at said desired operating frequency range, an impedance of the modulator to be connected at said feed region thereof; and: said conductive vane may be located at a selected angle of inclination between said first location on said upper conductor and said second location on said first conductive blade to attain a selected desired characteristic of said antenna element.

Further still, the conductive vane may be inclined outwardly, away from the feed region, such that the distance of the first location from the proximal end of the upper conductor is greater than that of the second location from the feed region.

Alternatively or additionally, the peripheral dimensions of the upper loop of the antenna element may be such that, combined they are substantially equal to a wavelength corresponding to the cut-off frequency.

Thus, more generally, the inventors have determined, through extensive innovative input, that by changing the location and/or inclination relative to the feed region of the conductive vane within the upper loop, the performance of the antenna element can be optimised in respect of a predetermined desired operating frequency range, particularly the operating frequency range of the system itself.

More specifically, the inventors have determined that by selecting the above-mentioned second location to be the minimum possible distance from the feed region without degrading the impedance match, the performance of the antenna element within the selected operating frequency range can be optimised. Furthermore, they have determined that characteristics or parameters of the antenna element can be influenced and optimised by selection of the inclination of the conductive vane (and, therefore, its length within an upper loop of given dimensions). The dimensions of the upper and/or lower loops can be selected according to a desired cut-off frequency of the antenna element, and the performance of the resultant antenna element, in a specified frequency range or ranges, can be optimised according to exemplary embodiments of the present invention.

In an exemplary embodiment as discussed above, the second location on the first blade member may be at least 1/6 of the length of the upper conductor, on the basis that if the second location is too close to the feed region, the impedance match may be unacceptably degraded. In various exemplary embodiments of the invention, the distance of the second location from the feed region may be between 1/6 and 4/5 of the length of the upper conductor. The conductive vane is, in certain embodiments of the present invention, inclined outwardly, away from the feed region. Thus, in exemplary embodiments of the invention, the distance of the first location from the proximal end of the upper conductor may be greater than that of the second location from the feed region. Furthermore, the conductive vane may be curved along at least a portion of its length. In exemplary embodiments, the distance of the first location from the proximal end of the upper conductor may be selected as a function of the length of the upper conductor and in accordance with the selected second location. Thus, for example, when the distance of the second location from the feed region is 1/6 of the length of the upper conductor, the distance of the first location from the proximal end of the upper conductor may be 1/5 or ¼ of the length of the upper conductor. Indeed, depending on the selected second location, the first location may be between 1/5 and 5/6 along the length of the upper conductor from its proximal end.

It will be appreciated that, within a monopole member of given dimensions, the inclination of the conductive vane is determinative of its length. The method may comprise the step of selecting the length of the upper conductor and/or the base conductor according to a selected desired cut-off frequency of the antenna element.

In one specific exemplary embodiment of the invention, the length of the upper conductor and the base conductor may be around 1000mm, and the desired operating frequency range may be around 400 - 700MHz. In this case, the distance between the proximal end of the base conductor and the proximal end of the upper conductor may be around 600mm. Thus, fifteen antenna elements could be accommodated in a 3 metre wide array or space to reduce coupling. In this case, and to match an impedance of a typical MFO transmission line, the width of the first and second blade portions may be around 200mm.

The cut-off frequency of an antenna element is defined as the frequency below which an antenna cannot propagate signals. In general, the major dimension of the above-described antenna element governs the lowest frequency at which the antenna can propagate a signal.

In an exemplary embodiment, the method may comprise the step of selecting the length of the upper conductor and/or the base conductor according to a selected desired cut-off frequency of the antenna element. In this case, the method may include steps of selecting a cut-off frequency of the antenna element, and selecting the peripheral dimensions of the upper loop such that, combined, they are substantially equal to a wavelength corresponding to the selected cut-off frequency. It will, therefore, be clear, that the larger the combined "circumferential" dimensions of the upper loop, the smaller will be the cut-off frequency of the antenna element.

Figure 1A is a schematic perspective view of an antenna element according to the prior art;

Figure 1B is a close-up schematic view of the feed region of the antenna element of Figure 1A;

Figure 2 is a schematic side view of an antenna element according to an exemplary embodiment of the present invention;

Figures 3A to 3E illustrate schematically various configurations of an antenna element according to an exemplary embodiment of the present invention, with progressively increasing distances of the conductive vane from the feed region of the antenna element;

Figure 4 is a graphical representation of test results for each of the five configurations illustrated in Figure 3;

Figure 5 is a graphical representation of calculations of performance from an antenna element according to an exemplary embodiment of the present invention compared with test results from two antenna elements according to the prior art;

Figures 6(i) to 6(v) illustrate various configurations of an antenna element according to an exemplary embodiment of the present invention, with progressively increasing inclinations of the conductive vane;

Figure 7 is a graphical representation of calculations of performance for each of the five configurations illustrated in Figure 6;

Figure 8 is a schematic view of an electromagnetic transmission system comprising antenna elements according to the present invention;

Figure 9 shows a graphical comparison of the temporal waveforms of a video waveform and a suitably modulated video waveform to cause a significant energy content shift to the microwave frequencies and accordingly is a graphical representation of the signals output by a pulse generator and a signal modulator, in the electromagnetic transmission system of figure 8;

Figure 10 shows the Fourier spectrums associated with the video waveform and modulated video waveform of Figure 10; and

Figure 11 shows a schematic diagram of an apparatus for generating microwave signals in accordance with the invention

In the following exemplary embodiments, an antenna is configured to be driven by microwave frequency oscillators (MFOs). However, it will appreciated that the present invention is not intended to be limited in this regard and that other multi-frequency pulsed energy sources can be used.

Throughout the specification, references are made to components being 'outward' or 'inward'. The term 'outward' has been used to indicate a direction that is towards the medium into which the antenna radiates (often referred to as boresight), and 'inward is used to indicate the opposite direction, i.e. away from the medium into which the antenna radiates. Furthermore, relative terms such as 'upper' and lower, and row and column, are used for convenience to distinguish between components so as to better explain the invention, so no absolute orientation is intended from the use of such terms alone.

Ultra Wide band (UWB) radiating systems with a peak power of around $10^{10}$ W are necessary for many applications. As explained above, creation of this type of radiating system has been achieved on the basis of multi element arrays with a peak radiation power of a single array element of around 0.1 - 1GW.

An antenna element has been proposed for this purpose in Koshelev, et al, "High-Power Ultrawideband Radiation Source with Multielement Array Antenna", in Proceedings of the 13th International symposium on High Current Electronics, Tomsk, Russia, July 2004. The described antenna element comprises an upper loop and a lower loop. The upper loop comprises a conductive loop defined by a first elongate conductor and a first conductive blade member that tapers outwardly to form a flare portion adjacent a distal end of the first elongate conductor. The lower loop comprises a conductive loop element defined by a second elongate conductor and a second conductive blade member that tapers outwardly to form a flare portion adjacent a distal end of the second elongate conductor, with the first and second conductive blade members defining, between their facing edges, a notch which opens outwardly from a feed region. It is to be appreciated that the term 'distal' used above and hereinafter is intended with reference to the feed region, i.e. outward from the feed region, and the term 'proximal' used above and hereinafter is intended with reference to the feed region, i.e. closer or closest to the feed region.

An antenna comprising a 4 x 4 array of such antenna elements is described, wherein the source comprises a pulse generator feeding the antenna via four co-axial transmission lines (i.e. one feeding each row of antenna elements).

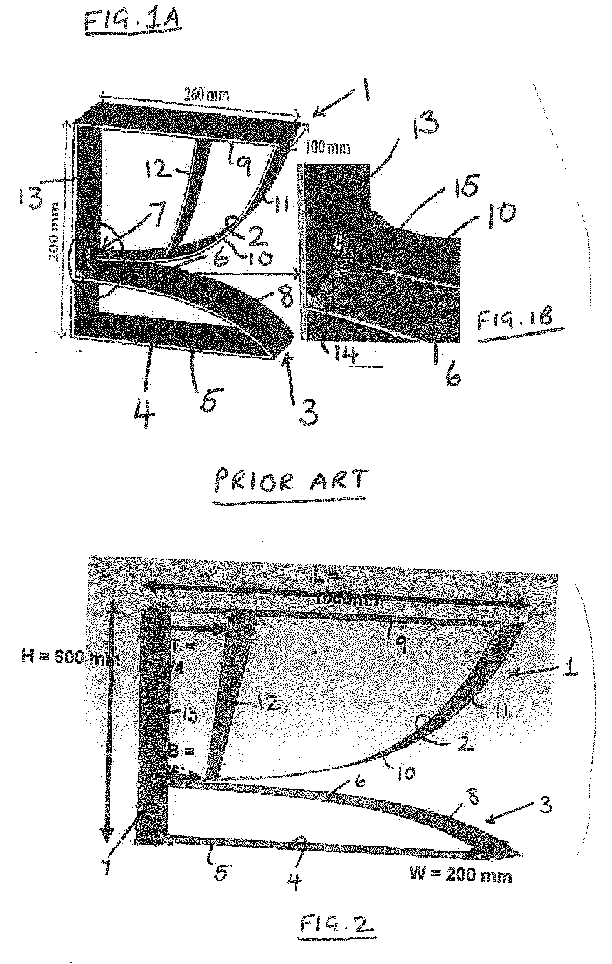

This type of antenna element was further explored by Godard, A., et al, "A transient UWB Antenna Array Used with Complex Impedance Surfaces", Hindawi, International Journal of Antennas and Propagation, Vol. 2010, wherein a modified antenna element is proposed that includes a conductive vane extending at an angle from the first conductive blade member to the upper elongate conductor so as to form a pair of adjacent loops. Such an antenna element is illustrated schematically in Figure 1A of the drawings, in which it can be seen that the element comprises an upper loop 1 comprising a first conductive loop element 2 and a lower loop 3 comprising a second conductive loop element 4. The conductive loop element 2 of the upper loop 1 comprises an elongate upper conductor 9 and a first conductive blade member 10, the first conductive blade member tapering outwardly from a feed region 7 to the distal end of the upper conductor 9 to form a first flare 11. The conductive loop element 4 of the lower loop 3 comprises an elongate base conductor 5, oriented substantially parallel to the upper conductor 9, and a second conductive blade member 6 which tapers outwardly from the feed region 7 to the distal end of the base conductor 5 to form a second flare 8.

A conductive vane 12 extends at an angle across the conductive loop of the monopole member, between the second blade member and the upper conductor, the vane 12 being inclined outwardly, i.e. away from the feed region 7. The feed region 7 is defined at a back plate 13. The connection or transition between the first blade member 6 and the inner surface of the back plate 13 is designed to achieve a good impedance match (S11 parameter lower the -10dB) over a desired frequency band (300MHz - 3GHz). As shown in Figure 1B of the drawings, the transition is formed of two sections: a first section 14 formed of metal and a second, central section 15 formed of, for example, PTFE, that provides high-voltage resistance.

However, it will be appreciated, that the described antenna element is intended for a specific use and frequency range, and has been developed and optimised for that use and frequency range. In contrast, an object of aspects of the present invention is to provide a method of antenna design that permits the design of an antenna element with a specified cut-off frequency, and permits the performance of such an antenna element or a wide band antenna comprising an array of such elements to be optimised according to specified characteristics, without increasing the dimensions of the antenna element to levels that would make it impractical for many applications.

The object of the above-mentioned reference (Godard) is to present a miniature antenna element which can be shown to have a cut-off frequency of 363MHz.

This characteristic is determined by the external characteristics of the antenna element, i.e. height H, length L and width W. In order to reduce the cut-off frequency of the element, it would be necessary to increase the external dimensions significantly, with the result that the antenna element, and any resulting multi-element array antenna would have impractically large dimensions for many applications, and may have an inadequate performance at various frequency ranges. Using the design calculations employed by Godard *et al*, a cut-off frequency of around 100MHz, would require an antenna element of dimensions:

$$W = 3000/10 = 300mm$$

$$H = 3000/5 = 600mm$$

$$L = 3000/3.85 = 780mm$$

Thus, the width of each antenna element would have to be 300mm. However, this also has additional drawbacks in terms of heat dissipation and, therefore, a negative effect on efficiency of the antenna element. Also, such dimensions may make it difficult to impedance-match the antenna element, or a multi-element antenna, to the transmission lines(s), which is a significant drawback as the feed design is, in many cases, critical to driving the antenna. Furthermore, such dimensions would not provide an optimised performance at specified frequencies and frequency ranges, and no methods or techniques are proposed in the prior art for solving these issues.

A method of antenna design, wherein its performance can be optimised at a specified operational frequency range and with reduced dimensions compared with known techniques may be achieved by altering the location and/or the inclination of the conductive vane defining the double loop in the upper loop of an antenna element of the type described above.

Referring to Figure 2, in an exemplary embodiment of the invention, the antenna element structure proposed is of the type described above, but having the following dimensions:

$$W = 200mm;$$

$$H = 600mm;$$

$$L = 1000mm;$$

which dimensions are selected to provide a cut-off frequency of ~100MHz.

In a method of manufacture according to an exemplary embodiment, impedance matching is performed to match the impedance of the antenna element to the transmission line of the desired radiation source (in a known manner) and the feed region 7 is thus optimised. Next, a selected operating frequency range for which the antenna element performance is to be optimised is selected. In this example, the frequency range is 400 - 700MHz.

The inventors have determined that by selecting the location of the conductive vane 12, the performance of the antenna element in the operating frequency range 400 - 700MHz can be optimised (in terms of return loss and efficiency.

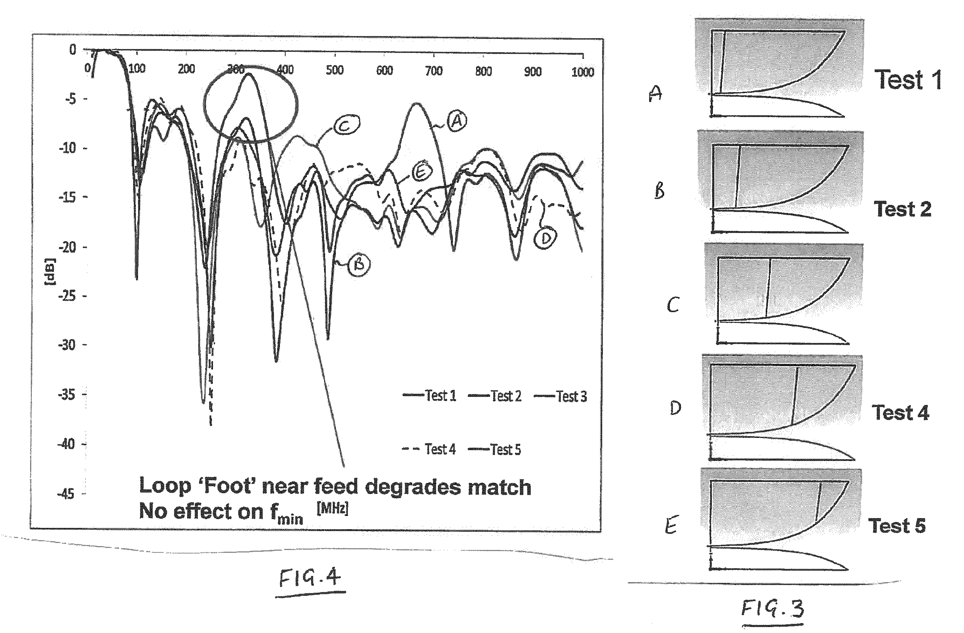

Referring to Figure 3 of the drawings, 5 possible locations of the conductive vane are illustrated, as A, B, C, D and E respectively. The inventors have determined, through extensive innovative input, that the key aspect of this element of the design method is the distance from the feed region 7 of the end of the conductive vane 12 where it meets the blade member of 10. In each of the five illustrated tests A-E, the inclination of the vane 12, outward, is substantially the same, at less than 10° relative to a vertical axis defined by the back plate 13, and the above-mentioned distance from the feed region 7 of the vane 12 where it meets the blade member 10 is made progressively larger.

As illustrated in Figure 4 of the drawings, it can be seen that if this distance is too small, the impedance match is degraded and the return loss (S11) is increased above an acceptable level at some frequencies. However, it can be seen that the performance of the antenna in the frequency range 400 - 700MHz is significantly improved in tests B, C and D at least (i.e. with the above-mentioned distance between about L/6 and 5L/8.

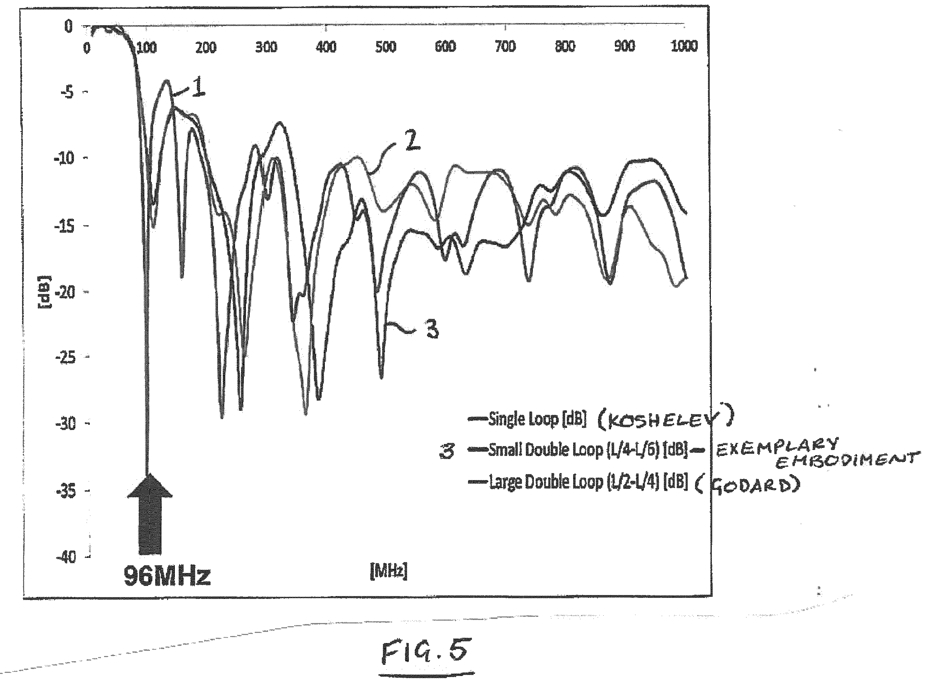

This performance can be seen in Figure 5 (reference 3) in comparison to that achieved with a comparably sized antenna element having (1) a single loop (Koshelev) and (2) a much larger double loop (Godard), wherein the above-mentioned distance is L/4 and the inclination of the vane is such that the distance of the other end of the vane from the proximal end of the upper conductor is L/2.

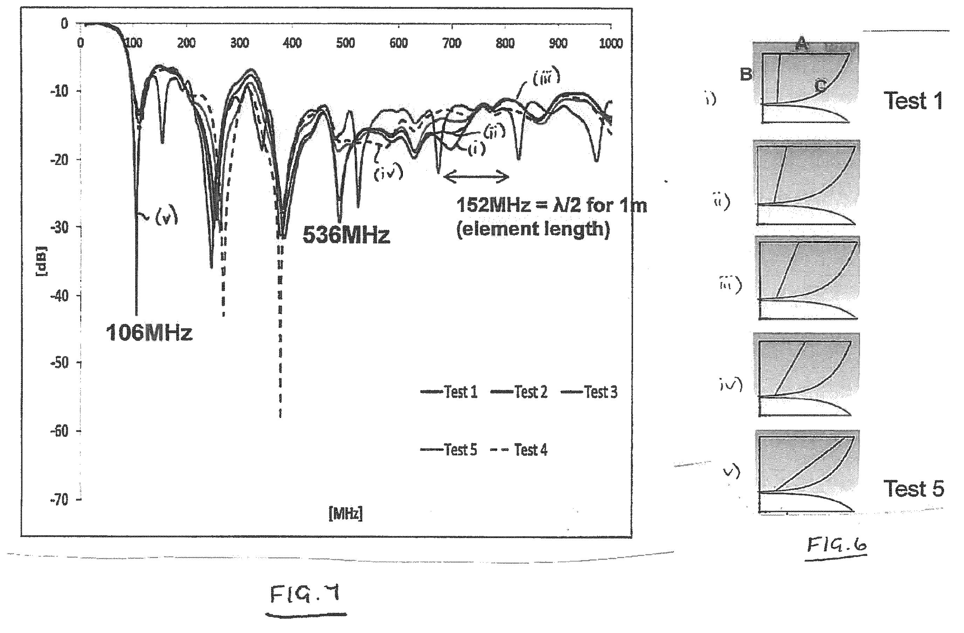

Referring now to Figure 6 of the drawings, having determined the optimum distance from the feed region of the conductive vane where it meets the blade member, the inventors have determined that the performance of the antenna element can be further optimised by changing the length of the inner loop (closest to the feed region). In effect, this method step comprises selecting an inclination of the conductive vane (outward) relative to the vertical axis defined by the back plate, or (equally) selecting the distance from the proximal end of the upper conductor of the conductive vane where it meets the upper conductor.

In the examples shown in Figure 6, each of the configurations tested has a 'bottom' distance (from the feed region) of around L/6 (corresponding to Test B of Figure 3), and each of the test configurations has a progressively larger loop length, ranging from about L/5 in test (i) to around 4L/5 in test (v). Thus, as shown in the calculated results illustrated in Figure 7 of the drawings, the performance of the antenna element can be optimised for a specified operating frequency range (in this case, 400 - 700MHz) by maintaining the minimum 'bottom' distance of the conductive vane (whilst maintaining the required impedance match), but increasing the size of the inner loop by increasing the 'top' distance (from the proximal end of the upper conductor) or inclination of the conductive vane. In view of the increased length of the upper and/or lower loops in comparison to the above-referenced Godard design, the antenna performance is further optimised by the methods proposed herein.

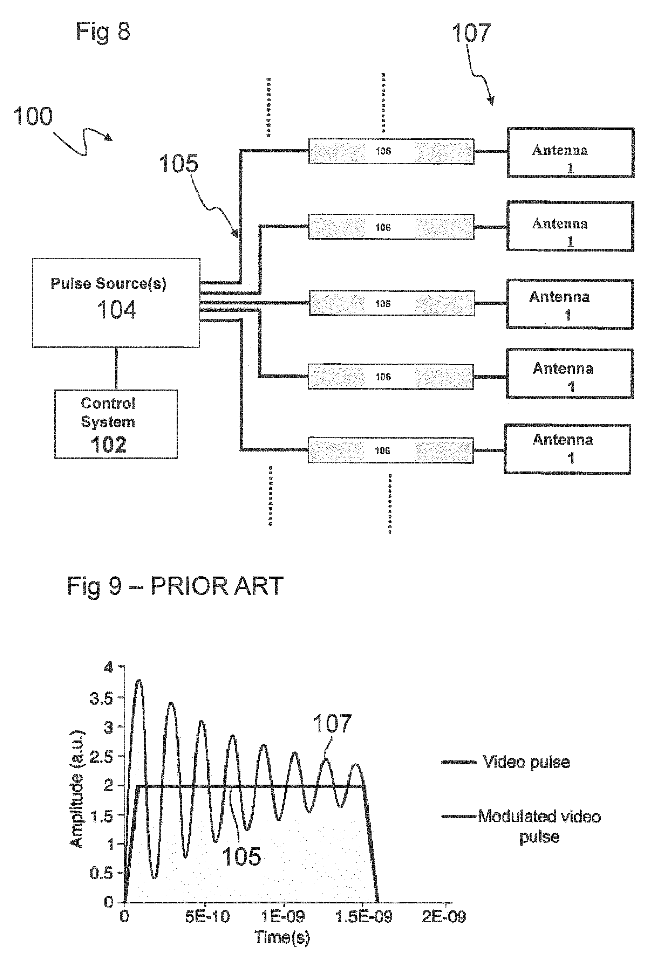

With reference to Figure 8, there is provided an electromagnetic transmission system 100 for transmitting a high power signal from a plurality of antenna elements 1. The plurality of antenna elements 1 may be arranged in an n x m array where n and m can be any positive integer. Alternatively, the plurality of antenna elements 1 may be arranged in other forms of array.

In transmission system 100, a control system 102 is connected to a pulse source 104. The pulse source 104 is independently connected to a plurality of modulators 106 (in the form of a Microwave Frequency Oscillator) such that an output 105 from the pulse source 104 can be fed into each of the modulators 106. Each modulator 106 is connected to an antenna element 1 such that the output 107 from a modulator 106 can be fed into its associated antenna 1.

In use the pulse source 104 generates at least one pulse signal 105. As shown in Figure 9, such a signal can have a steep rise, an extended period at a certain amplitude and then a steep decline back to zero amplitude. However, the exact characteristics of the pulse (e.g. rise time, plateau time, decline time, and repetition rate) may be varied or otherwise controlled by control system 102.

The pulse signal 105 output from the pulse source 104 is fed into the plurality of modulators 106. Each modulator 106 transforms signal 105 into a modulated signal 107 having an oscillatory characteristic as shown in Figure 9. The modulated signal 107 generated at each modulator 106 is fed into an antenna element 1 associated with each modulator 106.

As the modulated signal 107 propagates through the antenna element 1, (and indeed through the various loops of the antenna element 1) the signal is converted into an electromagnetic signal which can propagate through free space away from the system 100.

Further discussion of the modulators 106, which are in the form of a microwave frequency oscillator (MFO), is hereby provided with reference to Figures 9 to 11; however, such MFO devices in and of themselves are known in the art and more can be learned from for example the Applicant's previous application published as WO2007/141576 (and having Applicant reference XA2436).

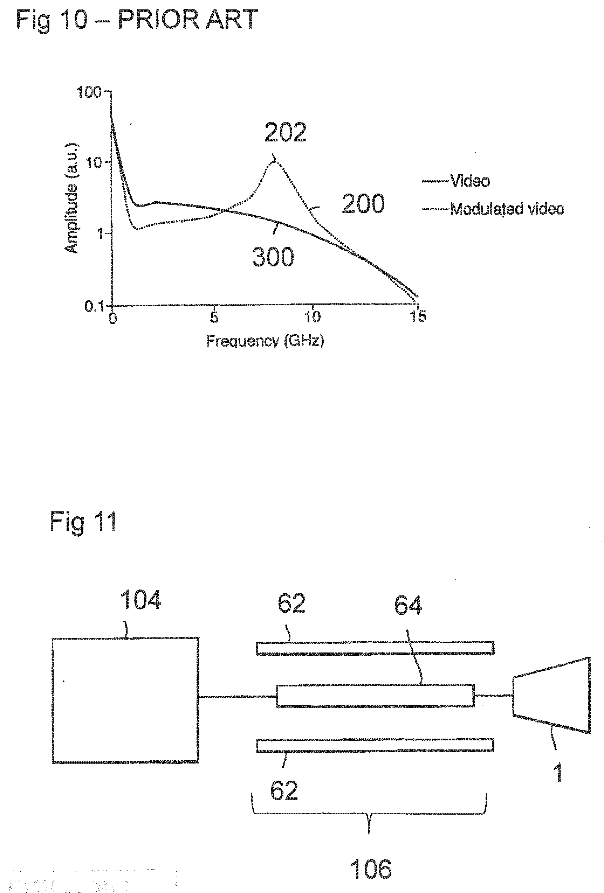

Figure 9 compares the time waveform of a typical electrical video impulse 105, with a 0.1 ns rise time and a 1.5ns pulse duration and the time waveform of a microwave modulated pulse 107. The electrical video pulse might typically be used to drive a UWB antenna 1 directly. Figure 10 shows the Fourier spectrums of the unmodulated video pulse waveform 300, and microwave modulated waveform 200. From Figure 10 it can be seen that the majority of energy in the video pulse 105 is contained in spectral components below the 100MHz region and that there is very little energy in the higher frequency components. Thus a large portion of the components of the video pulse would not be radiated by an antenna because most of the components would have a frequency below the cut-off of the antenna.

However, the Fourier spectrum of the modulated waveform 200 shows a major peak 202 at the modulation frequency. This represents energy shifted from the video frequencies up to the microwave frequencies and a major increase in the energy which can be practically radiated by an antenna because a larger portion of the modulated pulses' components have frequencies above the cut-off of the antenna.

The apparatus in Figure 11 includes a high power video pulse generator 104. The pulse generator 104 produces a pumping impulse. The pumping impulse is a high power video signal with duration typically 1 to 10ns and a pulse rise time of approximately 0.1 ns. The voltage amplitude of this pumping impulse is dependent on the application and may be from less than 10kV to several 100kV. Such pulse generators are typically switched by hydrogen thyratrons or high power semiconductors and are produced by specialist companies including Kentech Ltd and FID Technologies GmbH. The pulse generator may also contain some form of electromagnetic shock line for pulse sharpening. The pumping impulse is injected into a non-linear transmission line 64 (for example a coaxial transmission line) which contains magnetic material that is selected to support strong gyromagnetic characteristics. A magnetising structure 62 is provided around the outside of the transmission line 64 in order to apply bias to the magnetic material. The output of the non-linear transmission line 64 is fed into a suitable load structure such as an antenna 1.

Thus, more generally, the cut-off frequency of the antenna can be selected and the loop length/dimensions selected to achieve that selected cut-off frequency. The performance of the resultant antenna can then be optimised for a specified frequency range or ranges using methods according to exemplary embodiments of the present invention.

It will be apparent to a person skilled in the art, from the foregoing description, that modifications and variations can be made to the described embodiments without departing from the scope of the invention as defined by the appended claims.

**Claims**

1.  An electromagnetic signal transmission system having an operating frequency range and a cut-off frequency, the electromagnetic signal transmission system comprising:

    a control system,
    a pulse source in communication with the control system,
    a plurality of transmission units, each being operably connected to the pulse source, and
    each transmission unit comprising
    a modulator arranged to receive a pulse signal from the pulse source and output a modulated signal, and
    an antenna element arranged to receive the modulated signal from the modulator wherein the antenna element comprises at least two conductive loops.

2.  A transmission system according to claim 1 wherein the modulator tends to output a signal that has higher frequency components as compared to a signal input to the modulator.

3.  A transmission system according to claim 2 wherein the higher frequency components comprise microwave frequency components.

4.  A transmission system according to any one of the preceding claims wherein the modulator comprises a transmission line surrounded by a magnetising structure.

5.  A transmission system according to any one of the preceding claims wherein each antenna element comprises an upper loop and a lower loop, said upper loop comprising a first conductive loop element defined by an upper conductor and a first conductive blade member that tapers outwardly to form a flare portion adjacent a distal end of said upper conductor, said lower loop comprising a second conductive loop element defined by a base conductor and a second conductive blade member that tapers outwardly to form a flare portion adjacent a distal end of said base conductor, said first and second conductive blade members defining, between their facing edges, a notch which opens outwardly from a feed region, said upper loop further comprising an elongate conductive vane extending at an angle from a first location on said upper conductor to a second location on said first conductive blade to define a pair of loops within said upper loop.

6.  A transmission system according to claim 5 wherein an impedance of said antenna element substantially matches, at said desired operating frequency range, an impedance of the modulator connected at said feed region thereof; and:

    said conductive vane is located within said upper loop such that it extends from a selected second location on said first conductive blade to a first location on said upper conductor, said selected second location corresponding to a minimum distance from said feed region at which said impedance match is maintained.

7.  A transmission system according to claim 6 wherein the second location on the first blade member is at least 1/6 of the length of the upper conductor.

8.  A transmission system according to claim 5 or claim 6 wherein an impedance of said antenna element substantially matches, at said desired operating frequency range, an impedance of the modulator to be connected at said feed region thereof; and:

    said conductive vane is located at a selected angle of inclination between said first location on said upper conductor and said second location on said first conductive blade to attain a selected desired characteristic of said antenna element.

9.  A transmission system according to claim 8 wherein the conductive vane is inclined outwardly, away from the feed region, such that the distance of the first location from the proximal end of the upper conductor is greater than that of the second location from the feed region.

10. A transmission system according to any one of claims 5 to 9 wherein the peripheral dimensions of the upper loop are such that, combined they are substantially equal to a wavelength corresponding to the cut-off frequency.

FIG. 1A

FIG. 1B

PRIOR ART

FIG. 2

8

FIG. 3

Loop 'Foot' near feed degrades match
No effect on $f_{min}$

FIG. 4

Single Loop [dB] (KOSHELEV)

Small Double Loop (L/4-L/6) [dB] — EXEMPLARY EMBODIMENT

Large Double Loop (L/2-L/4) [dB] (GODARD)

96MHz

[MHz]

[dB]

Fig. 5

FIG.7

FIG.6

EP 3 182 151 A1

Fig 8

100

105

107

**Pulse Source(s)**
**104**

**Control System**
**102**

| | 106 | | Antenna 1 |
| | 106 | | Antenna 1 |
| | 106 | | Antenna 1 |
| | 106 | | Antenna 1 |
| | 106 | | Antenna 1 |

Fig 9 – PRIOR ART

—— Video pulse

—— Modulated video pulse

Fig 10 – PRIOR ART

Fig 11

Europäisches
Patentamt

European
Patent Office

Office européen
des brevets

# EUROPEAN SEARCH REPORT

Application Number

EP 15 25 0021

## DOCUMENTS CONSIDERED TO BE RELEVANT

| Category | Citation of document with indication, where appropriate, of relevant passages | Relevant to claim | CLASSIFICATION OF THE APPLICATION  (IPC) |
|---|---|---|---|
| X | EP 2 555 324 A2 (SELEX SISTEMI INTEGRATI SPA [IT]) 6 February 2013 (2013-02-06) | 1 | INV.<br>G01S7/282<br>H01Q7/00<br>H01Q13/08<br>H01Q21/06<br>H03K3/53 |
| Y | * abstract *<br>* paragraphs [0027], [0044], [0051], [0053], [0054], [0066], [0067], [0073] - [0075], [0117]; figures 1,2,5,10,11 * | 2-10 | |
| Y | US 2007/152875 A1 (SEDDON NIGEL [GB] ET AL) 5 July 2007 (2007-07-05)<br>* abstract *<br>* paragraphs [0005] - [0012]; figures 1-5 *<br><br>* paragraphs [0005], [0011], [0012]; figures 1-3 * | 2-4 | |
| Y | GODARD A ET AL:  "Size reduction and radiation optimization on UWB antenna", RADAR CONFERENCE, 2008. RADAR '08. IEEE, IEEE, PISCATAWAY, NJ, USA, 26 May 2008 (2008-05-26), pages 1-5, XP031376259, ISBN: 978-1-4244-1538-0<br>* the whole document * | 5-10 | |
| X | US 6 061 034 A (AGEE FORREST J [US] ET AL) 9 May 2000 (2000-05-09)<br>* abstract; figures 1-5 * | 1 | TECHNICAL FIELDS SEARCHED     (IPC)<br><br>G01S<br>H01Q<br>H03K |

The present search report has been drawn up for all claims

| Place of search | Date of completion of the search | Examiner |
|---|---|---|
| Munich | 13 June 2016 | Jäschke, Holger |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 15 25 0021

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2016

| Patent document cited in search report | | Publication date | Patent family member(s) | | Publication date |
|---|---|---|---|---|---|
| EP 2555324 | A2 | 06-02-2013 | EP 2555324 A2 | | 06-02-2013 |
| | | | US 2013169482 A1 | | 04-07-2013 |
| US 2007152875 | A1 | 05-07-2007 | AU 2003246021 A1 | | 07-06-2007 |
| | | | DE 10352157 A1 | | 26-02-2009 |
| | | | FR 2900001 A1 | | 19-10-2007 |
| | | | GB 2437355 A | | 24-10-2007 |
| | | | US 2007152875 A1 | | 05-07-2007 |
| US 6061034 | A | 09-05-2000 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007141576 A

**Non-patent literature cited in the description**

- **KOSHELEV et al.** High-Power Ultrawideband Radiation Source with Multielement Array Antenna. *Proceedings of the 13th International symposium on High Current Electronics,* July 2004

- **GODARD, A. et al.** A transient UWB Antenna Array Used with Complex Impedance Surfaces. *International Journal of Antennas and Propagation,* vol. 2010